# EUROPEAN PATENT APPLICATION

(11) **EP 4 362 098 A1**
(43) Date of publication of application: **01.05.2024**
(21) Application number: 22203524.8
(22) Date of filing: 25.10.2022
(51) Int. Cl.: H01L 27/146

(54) **ACTIVE PIXEL SENSOR AND METHOD FOR FABRICATING AN ACTIVE PIXEL SENSOR**

(71) Applicant: Infineon Technologies AG, 85579 Neubiberg (DE)
(72) Inventor: PARASCANDOLA, Stefano, 01109 Dresden (DE); OFFENBERG, Dirk, 01099 Dresden (DE)
(74) Representative: Lambsdorff & Lange Patentanwälte Partnerschaft mbB

(57) **Abstract**

An active pixel sensor comprises at least one pixel, comprising: a photoactive area, and at least one polysilicon component arranged over the photoactive area such that a photon may pass the polysilicon component prior to entering the photoactive area, wherein the polysilicon component comprises a diffraction structure configured to diffract incoming photons and thereby extend the light path of the incoming photons within the photoactive area.

## Description

### TECHNICAL FIELD

This disclosure relates in general to an active pixel sensor as well as to a method for fabricating an active pixel sensor.

### BACKGROUND

The quality of an image sensor may be judged by some key attributes, e.g. the image sensor's responsivity to incoming light. In particular infrared (IR) light and near-IR light may exhibit a comparatively long penetration depth in CMOS based active pixel sensors (APS) or specifically CMOS APSs fabricated in Si. This property of IR and near-IR light may make it necessary to provide APSs with a comparatively thick photoactive area in order for the sensor to be sufficiently sensitive. However, a particularly thick photoactive area may have several technical disadvantages. It may therefore be desirable to provide an APS comprising a photoactive area with a reduced thickness and/or to increase the sensitivity of an APS comprising a photoactive area with a given thickness. Improved active pixel sensors as well as improved methods for fabricating active pixel sensor may help solving these and other problems.

The problem on which the invention is based is solved by the features of the independent claims. Further advantageous examples are described in the dependent claims.

### SUMMARY

Various aspects pertain to an active pixel sensor, comprising: at least one pixel, comprising: a photoactive area and at least one polysilicon component arranged over the photoactive area such that a photon may pass the polysilicon component prior to entering the photoactive area, wherein the polysilicon component comprises a diffraction structure configured to diffract incoming photons and thereby extend the light path of the incoming photons within the photoactive area.

Various aspects pertain to a method for fabricating an active pixel sensor, the method comprising: fabricating at least one pixel of the active pixel sensor by fabricating a photoactive area and fabricating at least one polysilicon component over the photoactive area such that a photon may pass the polysilicon component prior to entering the photoactive area, wherein the polysilicon component comprises a diffraction structure configured to diffract incoming photons and thereby extend the light path of the incoming photons within the photoactive area.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a sectional view of an exemplary pixel of an active pixel sensor, wherein a polysilicon component of the pixel comprises a diffraction structure configured to diffract incoming photons.
Figures 2A-2E show a top view of exemplary polysilicon components for a pixel of an active pixel sensor, wherein the polysilicon component shown in Fig. 2A does not comprise a diffraction structure and the polysilicon components shown in Figs. 2B-2E comprise different exemplary diffraction structures.
Figure 3 shows a sectional view of a further exemplary pixel of an active pixel sensor, wherein a polysilicon component of the pixel comprises a diffraction structure configured to diffract incoming photons, for example one of the polysilicon components shown in Figs. 2B-2E.
Figure 4 schematically shows a photon being diffracted at the diffraction structure and subsequently being absorbed in the photoactive area of a pixel.
Figure 5 shows an exemplary active pixel sensor which may be configured to measure a distance to an object and/or measure the speed of the object.
Figure 6 is a flow chart of an exemplary method for fabricating active pixel sensors.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted.

The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "coupled", or "connected" elements. However, it is also possible that the "bonded", "coupled", or "connected" elements are in direct contact with each other. Also, the term "exemplary" is merely meant as an example, rather than the best or optimal.

In several examples layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole as well as techniques in which layers are deposited in a sequential manner.

An efficient active pixel sensor and an efficient method for fabricating an active pixel sensor may for example reduce material consumption, ohmic losses, chemical waste, etc. and thus enable energy and/or resource savings. Improved active pixel sensors and improved methods for fabricating an active pixel sensor, as specified in this description, may thus at least indirectly contribute to green technology solutions, i.e. climate-friendly solutions providing a mitigation of energy and/or resource use.

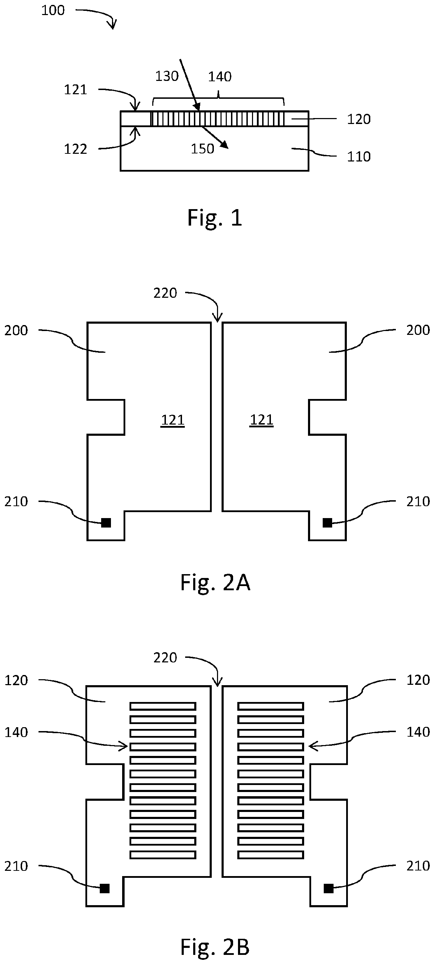

Figure 1 shows a pixel 100 which may for example be part of an active pixel sensor (APS). The active pixel sensor may comprise a single pixel 100 or a plurality of pixels 100 which may e.g. be arranged in an array. The active pixel sensor may for example be a CMOS sensor. The active pixel sensor may for example be (part of) a time of flight (ToF) sensor.

The pixel 100 comprises a photoactive area 110 and at least one polysilicon component 120. The photoactive area 110 may for example be fabricated in one or more epitaxial layers or in any other suitable part (or layer (s)) of the pixel 100. The polysilicon component 120 is arranged over the photoactive area 110 such that a photon 130 may pass the polysilicon component 120 prior to entering the photoactive area 110.

The polysilicon component 120 comprises a diffraction structure 140 configured to diffract incoming photons 130 and thereby increase the length of their light path 150 within the photoactive area 110.

In the photoactive area 110, photons 130 with the appropriate energy may be converted into electrons and holes by the inner photoelectric effect. The photoactive area 110 may comprise or consist of any material suitable for this purpose. The photoactive area 110 may for example comprise or consist of n-type Si. The pixel 100 may for example be configured to be sensitive in the infrared (IR) and near-IR spectrum, e.g. for incident light at a wavelength of about 940nm.

The polysilicon component 120 may comprise a first side 121 and an opposite second side 122. The first side 121 may face away from the photoactive area 110. The polysilicon component 120 may comprise or consist of undoped poly-Si.

According to an example, the pixel 100 comprises a dielectric material layer (not shown in Fig. 1) covering the first side 121 of the polysilicon component 120 such that incident photons 130 pass through the dielectric material layer prior to reaching the polysilicon component 120 and the photoactive area 110. The dielectric material layer may for example be configured to protect the polysilicon component 120 and/or the photoactive area 110 from the environment. The dielectric material layer may e.g. comprise or consist of an oxide, e.g. silicon oxide. The dielectric material layer may comprise a single layer or it may comprise a stack of individual layers.

According to an example, the polysilicon component 120 is (part of) a modulation gate of the pixel 100. For this reason, the polysilicon component 120 may be electrically connected to a metal wiring of the pixel 100 and/or the active pixel sensor. The pixel 100 may for example comprise two polysilicon components 120 arranged side by side over the photoactive area 110. The two polysilicon components 120 may be configured as demodulation gates for enabling indirect ToF measurement mode in the active pixel sensor.

The diffraction structure 140 comprised within the polysilicon component 120 may be configured to diffract incident light, in particular light of a wavelength the pixel 100 is configured to detect. The diffraction structure 140 may for example be configured to diffract incident light by 10° or more, or 20° or more, or 30° or more.

According to an example, the diffraction structure 140 comprises or consists of a diffraction grating. In other words, the diffraction structure 140 may comprise a plurality of slits or holes extending from the first side 121 completely through the polysilicon component 120 to the second side 122.

The diffraction structure 140 may have a structure size that is equal to or smaller than the wavelength λ of light the pixel 100 is configured to detect. In other words, slits or holes of the diffraction structure 140 may have a width equal to or smaller than λ and/or adjacent slits or holes have a pitch equal to or smaller than λ.

Figures 2A-2E show top views onto the first side 121 of pairs of polysilicon components, according to different examples. For reference purposes, Fig. 2A shows a pair of polysilicon components 200 which do not comprise a diffraction structure and Figs. 2B-2E show pairs of polysilicon components 120 with different exemplary diffraction structures 140. The pixel 100 may for example comprise a pair of polysilicon components 120 as shown in Figs. 2B-2E.

As shown in Figs. 2A-2E, the respective pairs of polysilicon components 120 may be arranged side by side in a pixel like the pixel 100 such that the first sides 121 face the same direction. The two polysilicon components 120 of each of the pairs shown in Figs. 2A-2E may be separated from each other by a gap 220. The gap 220 may for example be filled with a dielectric material. The polysilicon components 120, 200 may be electrically coupled to metal wiring of the pixel 100 and/or the active pixel sensor via metal contacts 210. The metal contacts 210 may for example be arranged close to the edge of the polysilicon components 120, 200, whereas the diffraction structures 140 may e.g. be arranged more in the center of the polysilicon components 120. The metal contacts 210 may for example comprise or consist of Al or Cu or an alloy thereof.

Since the polysilicon components 200 shown in Fig. 2A do not comprise any diffraction structures 140, incident photons are not diffracted or almost not diffracted when passing through the polysilicon components 200. Therefore, the incident photons may exhibit a comparatively large penetration depth into the photoactive area 110 below the polysilicon components 200 (the penetration depth being measured perpendicular to the first side 121 of the polysilicon components 200).

Due to the diffraction structures 140 of the polysilicon components 120 shown in Figs. 2B-2E on the other hand, incident photons are diffracted when passing through the polysilicon components 120. Diffracted photons may exhibit a comparatively smaller penetration depth than photons that were not diffracted. This may in turn improve the responsivity of the pixel 100 and/or the active pixel sensor.

Figure 2B shows a pair of polysilicon components 120, wherein the diffraction structure 140 comprises a plurality of slits. The slits may be arranged parallel to each other. The slits may e.g. be arranged in regular rows, for example in rows that are arranged perpendicular to the gap 220. However, it is also possible that the rows are arranged at any other angle with respect to the gap 220, for example 30°, 45°, or 60°. All slits of the diffraction structure 140 may essentially have the same shape, for example a rectangular shape. The shorter side of the rectangle as well as a pitch between adjacent slits may e.g. be equal to or smaller than the wavelength λ. The longer side of the rectangle may have any suitable length, e.g. a length of 10µm or less, or 5µm or less, or 2µm or less, or 1µm or less.

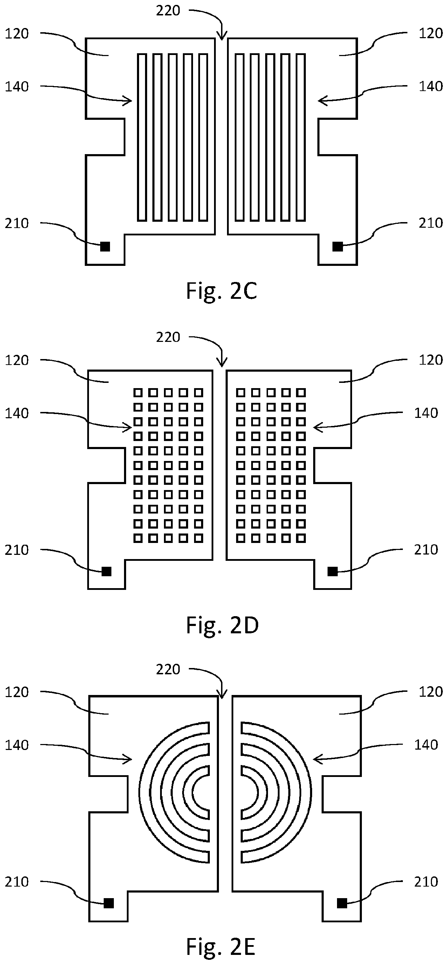

Figure 2C shows a pair of polysilicon components 120, wherein the diffraction structure 140 again comprises slits that are arranged parallel to each other. However, in the example shown in Fig. 2C, the slits are also arranged parallel to the gap 220 between the two polysilicon components 120. A length of the slits may be almost equal to a length of the gap 220. The slits of the example shown in Fig. 2C may have the same shape, dimensions and pitch described with respect to the slits of Fig. 2B.

In the example shown in Figure 2D, the diffraction structure 140 of the polysilicon components 120 comprises a plurality of holes. The holes may for example have a quadratic shape (as shown in Fig. 2D). However, the holes may also have a rectangular shape, a circular shape, an elliptic shape, an irregular shape, etc. The holes may for example be arranged in a checkerboard pattern. However, it is also possible that the holes are arranged in any different suitable pattern. The holes may have a size (edge length or diameter) and pitch equal to or smaller than λ.

In the example shown in Figure 2E, the diffraction structures 140 of the polysilicon components 120 comprise a plurality of slits in the form of concentric half rings. The slits of the example shown in Fig. 2E may have the same dimensions and pitch as described with respect to the example shown in Fig. 2B.

The diffraction structure 140 may account for a large part of the surface are of the first side 121 of the polysilicon components 120. For example, the diffraction structure 140 may account for 50% or more, or 70% or more, or 90% or more, or essentially the whole of the surface area of the first side 121.

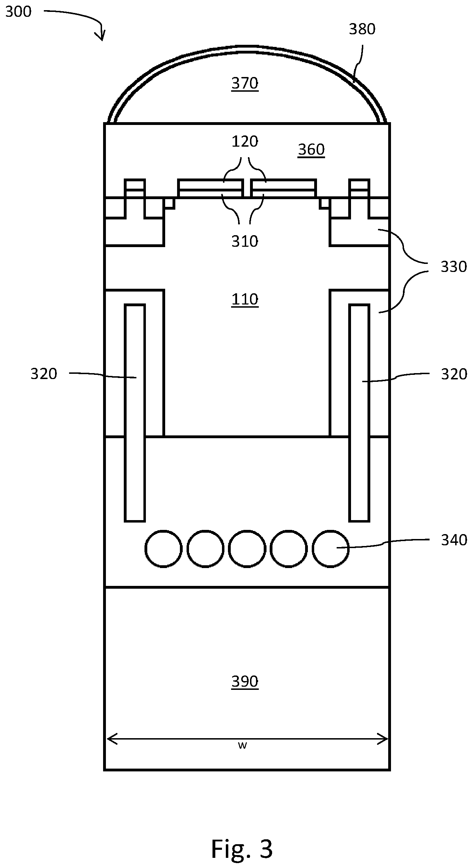

Figure 3 shows a further pixel 300 which may be similar or identical to the pixel 100. The pixel 300 may likewise be part of an APS, wherein the APS comprises a single pixel 300 or a plurality (e.g. an array) of pixels 300.

The pixel 300 comprises the photoactive area 110 and for example two polysilicon components 120 arranged on top of the photoactive area 110. The photoactive area 110 may e.g. comprise or consist of n-type silicon. The polysilicon components 120 may for example be modulation gates of the pixel 300.

According to an example, the polysilicon components 120 may be separated (and for example also electrically insulated) from the photoactive area 110 by a separation layer 310. The separation layer 310 may for example comprise or consist of a dielectric material, e.g. silicon oxide.

The pixel 300 may further comprise one or more trenches 320 which may be arranged laterally next to the photoactive area 110. The one or more trenches 320 may at least partially be arranged in a lateral material layer 330. The lateral material layer 330 may for example comprise or consist of p-type silicon. The lateral material layer 330 may be laterally arranged around at least part of the photoactive area 110.

The pixel 300 may further comprise a plurality of holes (or an additional trench) 340 arranged below the photoactive area 110. According to an example, the whole footprint of the photoactive area 110 or essentially the whole footprint of the photoactive area 110 may be covered by the holes (or additional trench) 340.

The trenches 320 and/or the holes (or additional trench) 340 may be configured to act as reflection structures for incident photons. In this manner, incident photons may be prevented from exiting the pixel and instead may be reflected back towards the photoactive area 110.

The pixel 300 may further comprise a plurality of photodiodes 350, for example two photodiodes 350. The photodiodes 350 may for example be pinned photodiodes.

The pixel 300 may further comprise a dielectric material layer 360 arranged over the polysilicon components 120. The dielectric material layer 360 may e.g. be a single layer or a stack of individual layers. The dielectric material layer 360 may be a back end of line (BEOL) layer stack. The dielectric material layer 360 may comprise or consist of an oxide material, e.g. silicon oxide.

The pixel 300 may further comprise a microlens 370. The microlens 370 may for example be arranged on top of the dielectric material layer 360. The microlens 370 may be configured to focus light towards the photoactive area 110.

The pixel 300 may further comprise an anti-reflective coating 380. The anti-reflective coating 380 may for example be arranged on the microlens 370.

Furthermore, the pixel 300 may comprise a substrate 390. The substrate 390 may for example comprise or consist of bulk silicon.

According to an example, the pixel 300 may further comprise a color filter configured to be transparent for light of a particular wavelength.

In the example described above, silicon is used as semiconductor material for the pixel 300. It is however also possible that any other suitable semiconductor material is used to provide the pixel 300.

The pixel 300 may e.g. have a width w in the range of 2µm to 15µm, for example 3µm to 10µm, or about 5µm, or about 7pm. A depth in the pixel 300 measured between the upper surface of the photoactive area 110 in Fig. 3 and the holes (or trench) 340 may for example be about 12pm, about 10µm, or about 8pm.

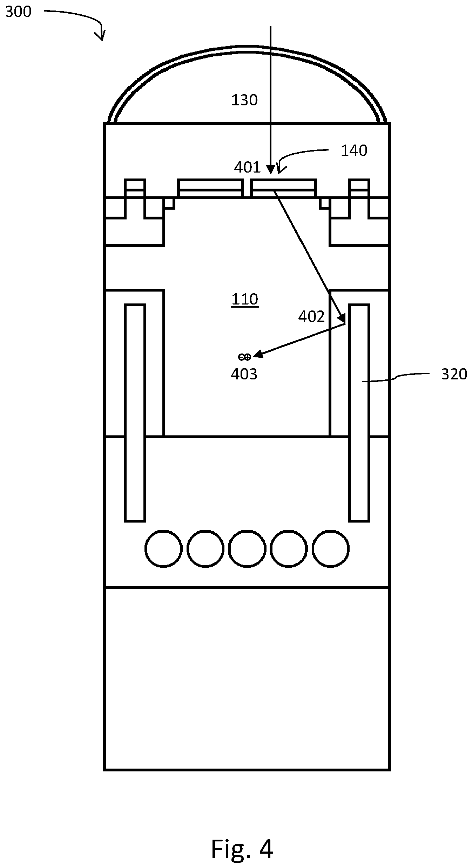

Figure 4 shows an exemplary light path of an incident photon 130 within the pixel 300 due to the diffraction structure 140 of the polysilicon components 120.

The incident photon 130 may pass through the anti-reflective coating 380, the microlense 370 and the dielectric material layer 360. At 401 the photon 130 is diffracted by the diffraction structure 140 of the polysilicon component 120. At 402 the photon 130 has passed through the photoactive area without being absorbed and is reflected by the trench 320. At 403 the photon is converted into an electron-hole-pair within the photoactive area 110 due to the inner photoelectric effect.

As shown in Fig. 4, the length of the path the photon 130 travels inside the photoactive area 110 may be increased due to diffraction at the diffraction structure 140. Without the diffraction structure 140, the photon 130 shown in Fig. 4 might have traversed the photoactive area 110 without being absorbed. The diffraction structure 140 therefore may enhance the sensitivity of the pixel 300 and consequently, the active pixel sensor.

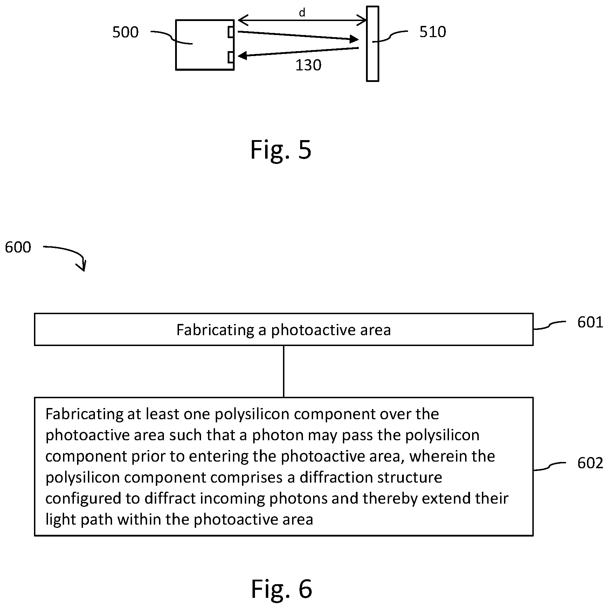

Figure 5 shows an exemplary active pixel sensor 500 which may comprise one or more pixels 100 or 300. The active pixel sensor 500 may for example be a time of flight (ToF) sensor configured to measure a distance d to an object 510 and/or a speed of the object 510. According to an example, the active pixel sensor 500 and an emitter for emitting photons 130 are part of the same unit. According to another example, the sensor 500 and the emitter are part of separate units.

According to an example, the active pixel sensor 500 (and consequently, the pixel 100 or 300) is configured for front side illumination. According to another example, the active pixel sensor 500 (and consequently, the pixel 100 or 300) is configured for backside illumination. In other words, the diffraction structures 140 described above may be used both in a front side illumination scheme as well as in a backside illumination scheme.

Figure 6 is a flow chart of a method 600 for fabricating an active pixel sensor like the active pixel sensor 500. The method 600 comprises fabricating at least one pixel of the active pixel sensor.

At 601 method 600 comprises an act of fabricating a photoactive area. This may e.g. comprise fabricating the photoactive area in one or more layers, e.g. one or more epitaxial layers. At 602 method 600 comprises an act of fabricating at least one polysilicon component over the photoactive area such that a photon may pass the polysilicon component prior to entering the photoactive area, wherein the polysilicon component comprises a diffraction structure configured to diffract incoming photons and thereby extend their light path within the photoactive area.

According to an example, method 600 comprises an optional act of electrically coupling the polysilicon component to a metal wiring of the active pixel sensor, for example such that the polysilicon component is configured as a modulation gate. Fabricating the photoactive area, respectively the polysilicon component may be done using any suitable front end of line (FEOL) and/or back end of line fabrication techniques, respectively. According to an example, method 600 comprises fabricating a plurality of pixels, in particular an array of pixels, in a batch process. The method 600 may in particular be performed on the wafer level.

The method 600 may further comprise an act of fabricating the diffraction structure which may comprise using any suitable structuring technique, for example chemical and/or physical structuring techniques. The diffusion structure may for example be fabricated by the same structuring process used to fabricate the outer shape of the polysilicon component. The diffusion structure may for example be fabricated in the same process as the polysilicon component or the diffusion structure may be fabricated in a subsequent process.

### EXAMPLES

In the following, the active pixel sensor and the method for fabricating an active pixel sensor are further explained using specific examples.

Example 1 is an active pixel sensor, comprising: at least one pixel, comprising: a photoactive area, and at least one polysilicon component arranged over the photoactive area such that a photon may pass the polysilicon component prior to entering the photoactive area, wherein the polysilicon component comprises a diffraction structure configured to diffract incoming photons and thereby extend the light path of the incoming photons within the photoactive area.

Example 2 is the active pixel sensor of example 1, wherein the polysilicon component is part of a modulation gate of the pixel.

Example 3 is the active pixel sensor of example 1 or 2, wherein the diffraction structure comprises a plurality of slits or holes extending through the polysilicon component.

Example 4 is the active pixel sensor of example 3, wherein the slits or holes have a width of 1µm or less.

Example 5 is the active pixel sensor of example 3 or 4, wherein the slits or holes are arranged in rows or in columns or in a checkerboard pattern or wherein the slits have a semicircular shape.

Example 6 is the active pixel sensor of one of the preceding examples, wherein the polysilicon component is electrically coupled to a metal wiring of the active pixel sensor.

Example 7 is the active pixel sensor of one of the preceding examples, further comprising: a dielectric material layer arranged over the polysilicon component such that an incoming photon passes through the dielectric material layer prior to passing the polysilicon component.

Example 8 is the active pixel sensor of example 7, further comprising: a microlens arranged over the dielectric material layer.

Example 9 is the active pixel sensor of example 7 or 8, wherein the polysilicon component comprises a first side facing away from the photoactive area, and wherein the dielectric material layer directly covers the first side.

Example 10 is the active pixel sensor of one of the preceding examples, further comprising: a reflective part arranged laterally next to the photoactive area, wherein the reflective part is configured to reflect photons back towards the photoactive area.

Example 11 is the active pixel sensor of example 10, wherein the reflective part comprises a trench within one or more layers of the active pixel sensor.

Example 12 is the active pixel sensor of one of the preceding examples, wherein the active pixel sensor is configured for front-side illumination, or wherein the active pixel sensor is configured for back-side illumination.

Example 13 is a method for fabricating an active pixel sensor, the method comprising fabricating at least one pixel of the active pixel sensor by: fabricating a photoactive area, and fabricating at least one polysilicon component over the photoactive area such that a photon may pass the polysilicon component prior to entering the photoactive area, wherein the polysilicon component comprises a diffraction structure configured to diffract incoming photons and thereby extend the light path of the incoming photons within the photoactive area.

Example 14 is the method of example 13, further comprising: electrically coupling the polysilicon component to a metal wiring of the active pixel sensor.

Example 15 is the method of example 13 or 14, wherein the polysilicon component is part of a modulation gate of the pixel.

Example 16 is an apparatus comprising means for performing the method of anyone of examples 13 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. An active pixel sensor (500), comprising:
at least one pixel (100, 300), comprising:
a photoactive area (110), and
at least one polysilicon component (120) arranged over the photoactive area (110) such that a photon may pass the polysilicon component (120) prior to entering the photoactive area (110),
wherein the polysilicon component (120) comprises a diffraction structure (140) configured to diffract incoming photons and thereby extend the light path of the incoming photons within the photoactive area (110).

2. The active pixel sensor (500) of claim 1, wherein the polysilicon component (120) is part of a modulation gate of the pixel (100, 300).

3. The active pixel sensor (500) of claim 1 or 2, wherein the diffraction structure (140) comprises a plurality of slits or holes extending through the polysilicon component (120).

4. The active pixel sensor (500) of claim 3, wherein the slits or holes have a width of 1µm or less.

5. The active pixel sensor (500) of claim 3 or 4, wherein the slits or holes are arranged in rows or in columns or in a checkerboard pattern or wherein the slits have a semicircular shape.

6. The active pixel sensor (500) of one of the preceding claims, wherein the polysilicon component (120) is electrically coupled to a metal wiring of the active pixel sensor (500).

7. The active pixel sensor (500) of one of the preceding claims, further comprising:
a dielectric material layer (360) arranged over the polysilicon component (120) such that an incoming photon passes through the dielectric material layer (360) prior to passing the polysilicon component (120).

8. The active pixel sensor (500) of claim 7, further comprising:
a microlens (370) arranged over the dielectric material layer (360).

9. The active pixel sensor (500) of claim 7 or 8, wherein the polysilicon component (120) comprises a first side (121) facing away from the photoactive area (110), and wherein the dielectric material layer (360) directly covers the first side (121) .

10. The active pixel sensor (500) of one of the preceding claims, further comprising:
a reflective part (320) arranged laterally next to the photoactive area (110), wherein the reflective part (320) is configured to reflect photons back towards the photoactive area (110).

11. The active pixel sensor (500) of claim 10, wherein the reflective part (320) comprises a trench within one or more layers of the active pixel sensor (500).

12. The active pixel sensor (500) of one of the preceding claims, wherein the active pixel sensor (500) is configured for front-side illumination, or wherein the active pixel sensor is configured for back-side illumination.

13. A method (600) for fabricating an active pixel sensor, the method (600) comprising fabricating at least one pixel of the active pixel sensor by:
fabricating (601) a photoactive area, and
fabricating (602) at least one polysilicon component over the photoactive area such that a photon may pass the polysilicon component prior to entering the photoactive area,
wherein the polysilicon component comprises a diffraction structure configured to diffract incoming photons and thereby extend the light path of the incoming photons within the photoactive area.

14. The method (600) of claim 13, further comprising:
electrically coupling the polysilicon component to a metal wiring of the active pixel sensor.

15. The method (600) of claim 13 or 14, wherein the polysilicon component is part of a modulation gate of the pixel.
